Europäisches Patentamt

(19) European Patent Office

Office européen des brevets

(11) Publication number: **0 132 037**
**B1**

(12) **EUROPEAN PATENT SPECIFICATION**

(45) Date of publication of patent specification: 02.12.87

(21) Application number: 84303775.5

(22) Date of filing: 05.06.84

(51) Int. Cl.⁴: **C 30 B 25/18,** C 30 B 29/60, C 30 B 25/16, C 30 B 25/04

(54) A process for the production of a compound crystal.

(30) Priority: 17.06.83 JP 109941/83

(43) Date of publication of application:
23.01.85 Bulletin 85/04

(45) Publication of the grant of the patent:
02.12.87 Bulletin 87/49

(84) Designated Contracting States:
DE FR GB

(56) References cited:
FR-A-2 402 009
US-A-3 642 521

Ullmanns Enzyklopädie der technischen
Chemie, Band 10, Verlag Chemie (1975), Pages
258-262

(73) Proprietor: SUMITOMO ELECTRIC INDUSTRIES
LIMITED
No. 15, Kitahama 5-chome Higashi-ku
Osaka-shi Osaka 541 (JP)

(72) Inventor: Namba, Hirokuni Osaka Works of
Sumitiomo Electric
Industries, Ltd. 1-3, Shimaya 1-chome
Konohama-ku Osaka (JP)

(74) Representative: Horton, Andrew Robert Grant
et al
BOULT, WADE & TENNANT 27 Furnival Street
London, EC4A 1PQ (GB)

**Description**

1. Field of the Invention

This invention relates to a process for the production of a compound bulk crystal by the chemical vapor deposition method (which will hereinafter be referred to as CVD method).

2. Description of the Prior Art

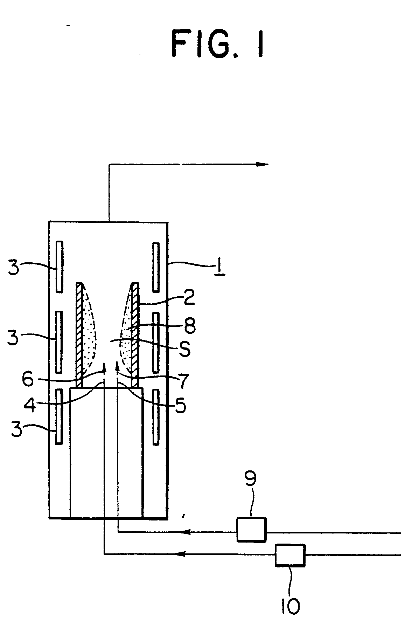

In the CVD method for the production of, for example, a compound AB (A and B being different elements), a CVD apparatus has hitherto been used as exemplified in Fig. 1. Fig. 1 shows a gaseous phase reactor 1 in which substrate 2 for deposition is provided and the inside is heated at a suitable temperature by means of heater 3. When raw material gases 6 (containing A) and 7 (containing B) are introduced from raw material gas feed nozzles 4 and 5 into reaction zone S held under suitable reaction conditions (pressure, temperature), A and B react in gaseous phase to deposit bulk crystal 8 of compound AB on substrate 2 for deposition. 9 and 10 are flow meters of raw material gases 6 and 7.

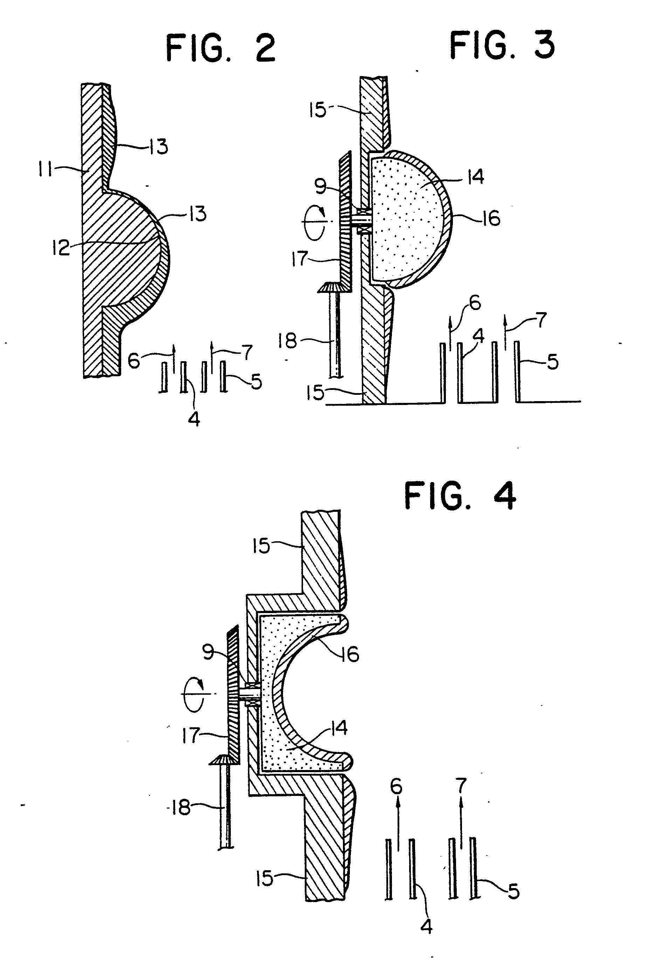

In the CVD method as described above, it is ordinary to use a substrate for deposition, corresponding to a shape of a crystal to be produced. When the deposition product has a plane shape or similar shape as shown in Fig. 1, the prior art method offers no problem, but when the deposition product has a hemispherical dome shape or similar shape as shown in Fig. 2, on the other hand, it offers the following problem. Referring to Fig. 2, substrate 11 for deposition has convex surface 12 of hemispherical dome and when raw material gases 6 and 7 each containing A and B are introduced from raw material gas feed nozzles 4 and 5, bulk crystal 13 of a compound AB is deposited on substrate 11. In this case, there occurs an ununiform distribution of thickness in bulk crystal 13 on substrate 11 as shown in Fig. 2, depending on the flow conditions of raw material gases and the surface shape of substrate 11 for deposition. That is, a thicker deposition than required takes place, thus resulting in greater loss of the raw materials and taking a longer period of time for growing the crystal, since the thinnest part of deposition constitutes a rate-determining step. This is an important disadvantage of the prior art.

Summary of the Invention

It is an object of the present invention to provide a process for the production of a compound crystal, whereby the disadvantage of the prior art can be overcome.

It is another object of the present invention to provide a process for the production of a compound crystal such as GaAs by the CVD method.

It is a further object of the present invention to provide a process for producing a compound bulk crystal having a convex or concave surface with a uniform thickness distribution of deposition, reduced loss of raw materials and shortened period of time for the growth of the crystal.

It is known, for example from Ullmanns Encyklopaedia der technischen Chemie, band 10, Verlag Chemie (1975) pages 258 to 262, to produce a compound bulk crystal by chemical vapour deposition on a rotating substrate.

The invention provides a process for producing a Group II—VI or Group III—V compound bulk crystal by means of chemical vapour deposition, in which method raw material gases are introduced into a reaction zone adjacent a substrate which as a planar portion surrounding a hemispherical portion, the axis of which is transverse the flow direction of the gases, characterised in that the said hemispherical portion is rotated, about the said axis and relative to the planar portion, during the deposition of the crystal.

Brief Description of the Drawings

The accompanying drawings are to illustrate the principle and the merits of the present invention in greater detail.

Fig. 1 is a cross-sectional view of a CVD apparatus of the prior art.

Fig. 2 is a cross-sectional view of a deposition substrate part in another CVD apparatus of the prior art.

Fig. 3 and Fig. 4 are cross-sectional views of examples of a deposition substrate part in a CVD apparatus used for the practice of the process according to the present invention.

Detailed Description of the Invention

The inventor has made efforts to overcome the drawbacks of the prior art in the production of a deposited bulk crystal, in particular, having a convex or concave surface by the CVD method and consequently, has found that to this end, it is effective to revolve a part of a deposition substrate. The present invention is based on this discovery.

A compound bulk crystal produced according to the invention is suitable for use as an infrared transmission dome.

The material of the compound crystal produced by the process of the present invention includes, for example, Group II—VI compounds such as ZnS, SnSe, $ZnS_xSe_{1-x}$ and CdTe, Group III—V compounds such as GaAs and InP, oxides, carbides, nitrides, fluorides and borides such as ZnO, $CaF_2$, $MgF_2$, BN and the like.

The present invention will now be illustrated in more detail with reference to the accompanying drawings.

Fig. 3 and Fig. 4 are cross-sectional views of examples of a deposition substrate used in the process of the invention. Referring to Fig. 3, in particular, the deposition substrate consists of hemispherical substrate 14 and plane substrate 15, hemispherical substrate 14 being rotatable to fixed plane substrate 15 by means of bearing 9 and driven by revolving and driving gear 17 and driving shaft 18. Fig. 4 shows the same structure except the substrate shape.

When the reaction zone is held under suitable reaction conditions (suitable pressure and temperature) and raw material gases 6 and 7 are introduced therein from raw material gas nozzles 4 and 5, bulk crystal 16 with a uniform thickness distribution is deposited on substrate 14 because this substrate is revolved.

Fig. 3 and Fig. 4 show only cases of hemispherical substrates for deposition, but the present invention is not intended to be limited to these examples. That is, the present invention can be applied to any convex or concave surfaces of substrates in addition to the hemispherical surfaces with the similar meritorious effects.

The process for the production of compound crystals as constructed above according to the present invention has the following advantages:

(a) Since a part of a deposition substrate having a convex or concave surface is revolved, the thickness of a bulk crystal deposited on the revolved substrate is made uniform and thus there can be obtained a compound bulk crystal with a uniform thickness distribution.

(b) Since the thickness distribution of a deposited crystal is uniform, the loss of raw materials can be reduced and the period of time required for the growth of the crystal can be shortened, resulting in lowering of the production cost.

Example 1

Using an apparatus as shown in Fig. 3, a dome-shaped bulk crystal of ZnS was deposited on hemispherical substrate 14 with a diameter of 150 mm.

Raw material gases were supplied from raw material gas feed nozzles 4 and 5 under the following conditions, while recovering hemispherical substrate 14 at a rate of 1 rpm:

| | |
|---|---|
| Metallic Zinc vapor + Ar gas | 0.2 Nl/min |
| $H_2S$ gas | 1.2 Nl/min |
| Pressure | 40 Torr |
| Temperature of Substrate 14 | 700°C |

In 100 hours, a Zn S bulk crystal of 5 mm in thickness was deposited with a uniform thickness distribution on substrate 14.

For comparison, when deposition of a ZnS bulk crystal was carried out for 200 hours on substrate 14 under the same conditions as set forth above except stopping substrate 14, there was obtained the bulk crystal with a very ununiform thickness distribution, i.e. partly less than 5 mm (e.g. 4.5 mm) and partly exceeding 5 mm (e.g. 15 mm).

Example 2

Using an apparatus as shown in Fig. 4, a dome-shaped bulk crystal of ZnSe was deposited on hemispherical (concave) substrate 14 with a diameter of 80 mm.

Raw material gases were supplied from raw material gas feed nozzles 4 and 5 under the following conditions, while revolving hemispherical substrate 14 at a rate of 1 rpm:

| | |
|---|---|
| Metallic Zinc vapor + Ar gas | 0.2 Nl/min |
| $H_2Se$ gas | 2 Nl/min |
| Pressure | 10 Torr |
| Temperature of Substrate 14 | 800°C |

In 70 hours, a ZnSe bulk crystal of 5 mm in thickness was deposited with a uniform thickness distribution on substrate 14.

**Claim**

A process for producing a Group II—VI or Group III—V compound bulk crystal by means of chemical vapour deposition, in which method raw material gases are introduced into a reaction zone adjacent a substrate which has a planar portion (15) surrounding a hemispherical portion (14), the axis of which is

**0 132 037**

transverse the flow direction of the gases, characterised in that the said hemispherical portion (14) is rotated, about the said axis and relative to the planar portion (15), during the deposition of the crystal.

**Patentanspruch**

Verfahren zur Herstellung eines Massivkristalls aus Verbindungen der Gruppen II—VI oder III—V durch chemische Dampfabscheidung, bei welchem Gase aus Ausgangsmaterial in eine Reaktionszone angrenzend an ein Substrat eingebracht werden, das einen planaren Teil (15) aufweist, der einen halbkugelförmigen Abschnitt (145) umgibt, dessen Achse quer zur Strömungsrichtung der Gase verläuft, dadurch gekennzeichnet, daß der halbkugelförmige Abschnitt (14) während der Ablagerung des Kristalls um die genannte Achse und relativ zu dem planaren Teil (15) gedreht wird.

**Revendication**

Procédé de fabrication d'un cristal en masse d'un composé du Groupe II—VI ou du Groupe III—V au moyen d'un dépôt de vapeur chimique, méthode dans laquelle des gaz de matières premières sont introduits dans une zone de réaction à proximité d'un substrat qui a une partie plane (15) entourant une partie hémisphérique (14), dont l'axe est transversal à la direction d'écoulement des gaz, caractérisé en ce que ladite partie hémisphérique (14) est entraînée en rotation, autour dudit axe et relativement à la partie plane (15), pendant le dépôt du cristal.

4

# FIG. I

# FIG. 2

# FIG. 3

# FIG. 4